# EUROPÄISCHE PATENTANMELDUNG

(11) **EP 1 715 078 A1**
(43) Veröffentlichungstag der Anmeldung: **25.10.2006**
(21) Anmeldenummer: 05008669.3
(22) Anmeldetag: 20.04.2005
(51) Int. Cl.: C23C 14/56, H01L 33/00

(54) **Kontinuierliche OLED-Beschichtungsanlage**

(71) Anmelder: Applied Films GmbH & Co. KG, 63755 Alzenau (DE)
(72) Erfinder: Bender, Marcus, Dr., 63456 Hanau (DE); Hoffmann, Uwe, Dr., 63755 Alzenau (DE); Haas, Dieter, 63486 Bruchköbel (DE); Englert, Ulrich, 63869 Heigenbrücken (DE); Lehr, Heino, 63517 Rodenbach (DE); Gürke, Achim, 63739 Aschaffenburg (DE); Manz, Dieter, 72141 Walddorfhäslach (DE)
(74) Vertreter: Lang, Christian

(57) **Zusammenfassung**

Die vorliegende Erfindung betrifft eine Vorrichtung und ein Verfahren zur insbesondere kontinuierlichen Herstellung von mit organischen elektrolumineszierenden Materialien (OLED) versehenen Substrat, insbesondere OLED-Displays, -Bildschirmen, -Anzeigen und sonstigen Beleuchtungselementen, bei denen die Vorrichtung einen Vakuumraum und eine Transporteinrichtung zum Transport der zu beschichtenden Substrate aufweist, welche zumindest teilweise entlang des Vakuumraums angeordnet ist und Träger für die Substrate umfasst, wobei die Transporteinrichtung zumindest eine Endlosschleife für den Transport der Träger umfasst und wobei der Vakuumraum zumindest zweigeteilt mit einem ersten Teil (3), in dem ein erster Abschnitt der Transporteinrichtung für den Transport der Träger in eine erste Richtung (Substrattransportrichtung) vorgesehen ist, und mit einem zweiten Teil (4), in dem ein zweiter Abschnitt der Transporteinrichtung für den Transport der Träger in eine zweite Richtung (Trägerrücktransportrichtung) vorgesehen ist. Entsprechend werden die für die Strukturierung der OLED-Beschichtungen erforderlichen Masken in vorteilhafter Weise direkt beim Rücktransport gereinigt und es ist keine Maskenvorratshaltung erforderlich.

## Beschreibung

Die vorliegende Erfindung betrifft eine Vorrichtung nach dem Oberbegriff des Anspruchs 1 bzw. ein Verfahren zur Herstellung von mit organischen elektrolumineszierenden Materialien (OLED) versehenen Substraten.

Bei technischen Bedienungselementen und in der Unterhaltungselektronik gewinnen flache Bildschirme und Anzeigen zunehmend an Bedeutung. Eine interessante Realisierung derartiger flacher Bildschirme ist durch sogenannte OLED-Displays bzw. -Anzeigen gegeben, bei denen organische elektrolumineszierende Materialien zwischen Elektroden auf einem flachen transparenten Substrat abgeschieden werden, um mittels der Ansteuerung über die Elektroden Lichtemissionen zu erzeugen, die zur Bilddarstellung verwendet werden können.

Zur Herstellung derartiger OLED-Bildschirme werden Vakuumbeschichtungsverfahren eingesetzt, die üblicherweise in sogenannten Cluster Tools angewandt werden. Hierbei gibt es üblicherweise verschiedene um ein Zentrum angeordnete Module, in denen verschiedene Beschichtungsschritte durchgeführt werden, wobei die zu beschichtenden Substrate durch einen zentral angeordneten Roboter in die entsprechenden Module eingeführt, von diesen entnommen und zum nächsten Modul transportiert werden. Eine derartige Technik weist zwar hinsichtlich der Reinheitsanforderungen und Prozessbedingungen in den einzelnen Modulen gewisse Vorteile auf, ist jedoch für eine wirtschaftliche Massenherstellung von entsprechenden OLED-Bildschirmen nicht sinnvoll.

Deshalb gibt es bereits im Stand der Technik Vorschläge für sogenannte In-Line-Anlagen, die eine kontinuierliche Abfolge der verschiedenen notwendigen Beschichtungsschritte ermöglichen. Als Beispiele sind hier zu nennen die JP 2003332052 A, die WO 03/090260 A2 sowie die WO 03/043067 A1.

In der JP 2003332052 A wird eine ringförmige Anordnung verschiedener Beschichtungsstationen, beispielsweise für die Abscheidung von rot-, grün- und blau emittierenden elektrolumineszierenden Materialien vorgeschlagen, wobei eine separate Reinigungsstation für die zur Strukturierung der Beschichtungen notwendigen Masken außerhalb des Ringes an einer Ausschleusstation vorgeschlagen ist. Eine derartige Anlagenkonfiguration erfordert jedoch einen hohen Aufwand für den separaten Transportweg für die gereinigten Masken zur Einschleusstation sowie hinsichtlich der separaten Anordnung der Reinigungsstationen.

In der WO 03/090260 A2 ist eine Vorrichtung zur Abscheidung von mehrlagigen Beschichtungen auf Substraten beschrieben, wobei die Substrate auf einer im wesentlichen linearen Bahn mehrmals durch die Beschichtungsanlage geführt werden, um die unterschiedlichen Schichten abzuscheiden. Obwohl damit eine kontinuierliche In-Line-Anlage verwirklicht ist, weist eine derartige Anlage durch das mehrfache Durchfahren des Substrats durch die Beschichtungsanlage Nachteile auf.

In der WO 03/043067 A1 ist eine Vorrichtung zur Herstellung von organischen elektrolumineszierenden, Licht emittierenden Vorrichtungen für die Massenproduktion beschrieben, bei welcher das zu beschichtende Substrat auf einem Träger angeordnet ist, welcher beispielsweise entlang einer Gleisanordnung durch eine Vakuumbeschichtungsanlage geführt wird und bei dem die Träger mit dem Substrat in benachbarte Beschichtungskammern eintauchen können, um dort verschiedenste Beschichtungsprozesse durchzuführen. Auch hier ist der Aufwand für das Absenken der Substrate in die einzelnen Beschichtungskammern sowohl zeitlich beim Beschichtungsprozess als auch konstruktiv sehr hoch. Zudem müssen sämtliche Prozesse wie Substratreinigung, Maskenanordnung für die Strukturierung und Reinigung der Masken sowie die Beschichtungen in den verschiedenen Kammern nacheinander durchgeführt werden.

Es ist deshalb Aufgabe der vorliegenden Erfindung, eine Beschichtungsanlage bzw. eine Vorrichtung zur insbesondere kontinuierlichen Herstellung von mit organischen elektrolumineszierenden Materialien (OLED) versehenen Substraten, insbesondere OLED-Displays, - Bildschirme, -Anzeigen oder sonstigen OLED-Beleuchtungselementen zu schaffen, bei denen die Nachteile des Standes der Technik vermieden werden und insbesondere eine einfache und günstige Möglichkeit zur massentechnischen Herstellung von OLED-Elementen bei geringem Platzbedarf unter Berücksichtigung hoher Qualitätsansprüche für die OLED-Produkte bereit gestellt wird. Insbesondere soll die entsprechende Vorrichtung einfach herstellbar bzw. das Verfahren einfach betreibbar sein.

Diese Aufgabe wird gelöst durch eine Vorrichtung mit den Merkmalen des Anspruchs 1 sowie ein Verfahren mit den Merkmalen des Anspruchs 13. Vorteilhafte Ausgestaltungen sind Gegenstand der abhängigen Ansprüche.

Die vorgeschlagene Lösung zeichnet sich dadurch aus, dass die Beschichtungsanlage bzw. Vorrichtung nach einem Doppelkammerprinzip aufgebaut wird, d.h. dass der gesamte Vakuumraum der Vakuumbeschichtungsanlage vorzugsweise entlang der Längsachse in zwei Teile unterteilt wird, wobei ein erster Teil des Vakuumraums dazu verwendet wird, die mit den Substraten beladenen Träger zum Transport der Substrate durch die Beschichtungsanlage von der Belade- zur Entladestation zu transportieren und der andere, zweite Teil der Anlage zur Rückführung und Reinigung der Substratträger und insbesondere der für die Strukturierung notwendigen Masken dient. Dies hat den Vorteil, dass eine sehr kompakte Anlage mit echter kontinuierlicher Betriebsweise als so genannte In-Line-Anlage verwirklicht werden kann, wobei sowohl eine Vorratshaltung für Träger als auch von Masken durch die Führung von Trägern und/oder Masken in Endlosschleifen vermieden wird.

Durch das Doppelkammerprinzip ist ferner ein einfacher Aufbau und ein einfacher Betrieb, insbesondere auch zur Erzeugung des Vakuums möglich, wobei insbesondere die Doppelkammem als universell verwendbare Module ausgestaltet sein können, so dass je nach Bedarf in den entsprechenden Doppelkammermodulen entsprechende Prozesswerkzeuge und sonstige Einrichtungen angeordnet werden können. Dies erleichtert auch den Umbau deutlich. Außerdem ermöglicht ein derartiger Aufbau einen ununterbrochenen Transport von Substraten bzw. Trägern und/oder Masken zur Mikrostrukturierung der Beschichtungen im Vakuum. Damit wird eine Verunreinigung der Träger oder Masken durch die Umgebung vermieden.

Ferner können, falls erforderlich, auch Schleusenkammern und/oder Schleuseneinrichtungen sowie Abschließvorrichtungen zwischen den einzelnen Kammern oder Kammermodulen vorgesehen sein, damit bestimmte Bereiche zur Vermeidung von Kontaminationen oder im Falle der teilweisen Belüftung der Anlage abgeschottet werden können.

Neben der Endlosschleife für den Transport der Träger, die sich mit dem ersten Abschnitt der Transporteinrichtung in Substrattransportrichtung entlang des ersten Teils des Vakuumraums erstreckt und mit dem gegengerichteten zweiten Abschnitt der Transporteinrichtung, also in Trägerrücktransportrichtung, im zweiten Teil des Vakuumraums bzw. der Vakuumdoppelkammem erstreckt, sind in vorteilhafter Weise zusätzlich noch vorzugsweise mehrere zweite Endlosschleifen zum Transport von Masken, die zur Strukturierung bzw. Mikrostrukturierung der Beschichtungen dienen, vorgesehen. Die entsprechenden Transportanordnungen der zweiten Endlosschleifen für den Maskentransport befinden sich mit einem ersten Abschnitt ebenfalls in dem Teil des Vakuumraums, in dem der Substrattransport vom Einschleusbereich in den Ausschleusbereich stattfindet und mit einem zweiten Abschnitt für den Rücktransport im zweiten Teil des Vakuumraums.

Vorzugsweise verwenden die Transporteinrichtungen für die Träger und die Transportanordnungen für die Masken zum Teil die gleichen Transportmittel und Handhabungseinrichtungen, so dass zumindest teilweise der Transport gemeinsam erfolgt. Insbesondere dienen die Substratträger vorzugsweise auch als Maskenträger für den zumindest teilweisen Rücktransport der Masken.

Vorzugsweise erfolgt der Wechsel von dem ersten Abschnitt der Transporteinrichtung bzw. der Transportanordnung auf den zweiten Abschnitt der Transporteinrichtung bzw. Transportanordnungen in den Endlosschleifen sowie umgekehrt in den Substratladestationen und/oder Substratentladestationen, in denen die Substrate an den Trägern angeordnet bzw. von diesen entfernt werden und/oder in den Maskenaufbringungsstationen und/oder Maskenabnahmestationen, an denen die Masken den Substraten zugeordnet bzw. auf diesen angeordnet werden bzw. wieder von diesen entfernt werden.

Nach einer bevorzugten Ausführungsform ist ein Rotationsmodul vorgesehen, welches in einer Station sowohl den Maskenwechsel für zwei benachbarte Beschichtungsbereiche durchführt als auch den Transfer der Masken von dem Beschichtungsabschnitt in den Reinigungsabschnitt und umgekehrt bewerkstelligt, wobei an dem Rotationsmodul entsprechende Maskenaufbringungs- und/oder -abnahmestationen und/oder Maskenausrichtungsstationen sowie Halteelemente für die Masken vorgesehen sind. Das Rotationsmodul umfasst einen Drehmechanismus mit einem Drehtisch, an dem zwei Aufnahmen mit Übergabepositionen für Substratträger sowohl aus dem ersten Abschnitt als auch aus dem zweiten Abschnitt der Transporteinrichtung vorgesehen sind, wobei durch Drehung des Drehtisches um 180° die Auf nahmen in Übergabepositionen des jeweiligen anderen Transportabschnitts und bei Drehung um 90° in Übergabepositionen zur Überführung in einen benachbart angeordneten Maskenwechselbereich gebracht werden können. Zunächst werden hierbei die Masken von den Substratträgem abgenommen, dann werden die Substratträger der jeweils anderen wartenden Maske zugeordnet und nach Aufbringung im Transportsystem weiter bewegt.

Die Endlosschleifen können durch jeweils eine einzige kontinuierlich arbeitende Transporteinrichtung oder durch eine Vielzahl von Handhabungsgeräten und Transportmitteln, bei denen beispielsweise die Substrate und/oder Träger bzw. die Masken von einer Einrichtung auf die andere übergeben werden, realisiert werden.

Durch die erfindungsgemäße Ausgestaltung der Vorrichtung ist es möglich, bei entsprechenden Verfahren zur Herstellung von OLED-Elementen, die für die Strukturierung der Beschichtungen notwendigen Masken bzw. Schattenmasken direkt auf dem Rücktransport zu reinigen und eine Maskenvorratshaltung zu vermeiden sowie insgesamt die Anzahl der erforderlichen Masken zu minimieren.

Weitere Vorteile, Kennzeichen und Merkmale der vorliegenden Erfindung werden bei der nachfolgenden detaillierten Beschreibung zweier Ausführungsbeispiele anhand der beigefügten Zeichnungen deutlich. Die Zeichnungen zeigen hierbei in rein schematische Weise in
- Fig. 1: eine Draufsicht auf eine erfindungsgemäße Vorrichtung;
- Fig. 2: eine Draufsicht auf eine zweite Ausführungsform einer erfindungsgemäßen Vorrichtung;
- Fig. 3: eine Teilansicht der Vorrichtung aus Fig. 2 mit entsprechenden Trägern und Masken;
- Fig. 4: eine schematische Darstellung eines Teils des Verfahrensablaufs bzw. -betriebs der Vorrichtung aus Fig. 2 und 3; und in
- Fig. 5: eine Draufsicht auf ein Rotationsmodul in einer weiteren Ausführungsform der Erfindung.

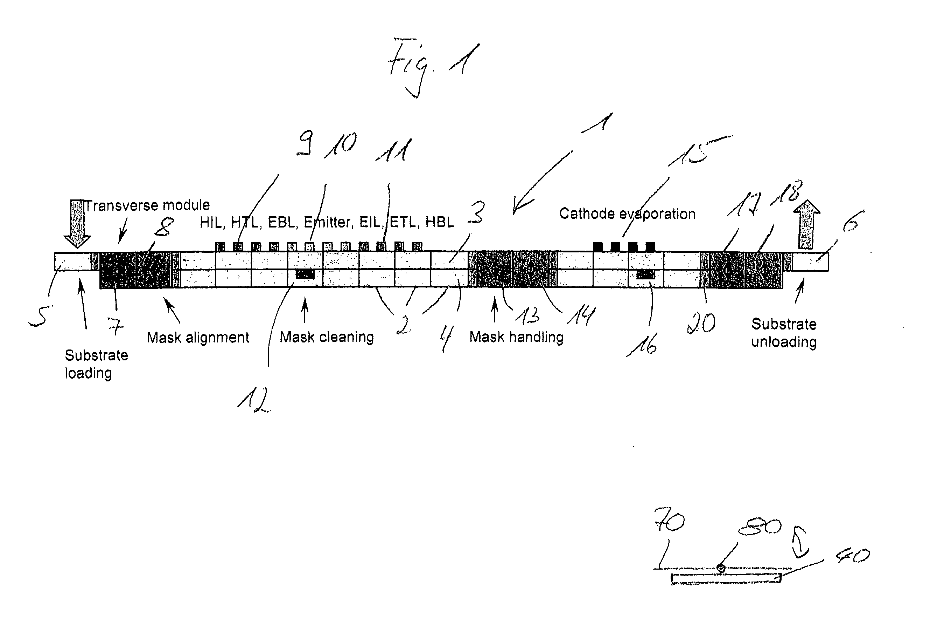

Fig. 1 zeigt eine erfindungsgemäße Vorrichtung mit einer Konfiguration zur Erzeugung von weißem Licht emittierenden organischen LEDs (OLED). Die Vorrichtung 1 umfasst eine Vielzahl von hintereinander angeordneten Vakuumdoppelkammern 2, die jeweils zweigeteilt in die Teile 3 und 4 sind und mit ihren Nachbarkammern einen Vakuumraum bilden. Neben der Teilung des Vakuumraums in die beiden Teile 3 und 4 entlang der Längsachse der Vorrichtung ist der Vakuumraum zudem durch die Maskenaufbringungsstation 14 und die Maskenabnahmestation 13 in dem in Fig. 1 gezeigten Ausführungsbeispiel in zwei Bereiche unterteilt, wobei auch eine Unterteilung in mehrere Bereiche vorliegen kann. Die Unterteilung durch die Maskenaufbringungs- und -abnahmestationen 13 und 14 ist jedoch genauso wenig wie die Längsunterteilung in die Teile 3 und 4 dahingehend zu verstehen, dass unterschiedliche Vakuumverhältnisse vorliegen. Obwohl dies im Einzelfall möglich ist, können vielmehr auch gleiche Vakuumverhältnisse herrschen. Die Unterteilung ist nur dahingehend zu verstehen, dass der Vakuumraum nicht gleich bleibend durchgängig ist. Allerdings bilden die Vakuumdoppelkammern 2 mit ihren jeweiligen Teilen 3 und 4 durchgängig Transportbereiche, die auch durch die Maskenaufbringungs- und -abnahmestationen 13 und 14 nicht unterbrochen werden, während ein Übergang zwischen den Teilen 3 und 4 nur in bestimmten Bereichen möglich ist. Auch die Unterteilung des Vakuumraums durch die Module der Vakuumdoppelkammem 2 beeinflusst die grundsätzliche Unterteilung in die Teile 3 und 4 nicht.

Zusätzlich kann eine Trennung dadurch erfolgen, dass Schleusen oder Abschließelemente 20 vorgesehen sind, die eine Abtrennung bzw. Abschottung einzelner Bereiche des Vakuumraums ermöglichen. Vorzugsweise ist der Vakuumraum aus gleichartigen Modulen aufgebaut, die entsprechend ihrer Verwendung als Maskenaufbringungs- und -abnahmestationen oder Substratlade- und -entladestationen, Beschichtungsstationen und dergleichen unterschiedlich ausgestattet sind.

Die Vorrichtung 1 weist insgesamt einen linearen Aufbau auf, wobei an dem einen Ende eine Substrateinschleuseinrichtung 5 und am gegenüberliegenden Ende eine Substratausschleuseinrichtung 6 vorgesehen sind. Neben dem linearen Aufbau ist selbstverständlich auch ein anderer Aufbau mit entsprechenden Kurven oder einem Transport um die Ecke möglich. Durch die Substrateinschleuseinrichtung 5 und die Substratausschleuseinrichtung 6 kann ein zu beschichtendes Substrat von Umgebungsbedingungen oder einer anderen Vakuumbehandlungsanlage in den Vakuumraum der Vorrichtung 1 eingeschleust bzw. wieder ausgeschleust werden.

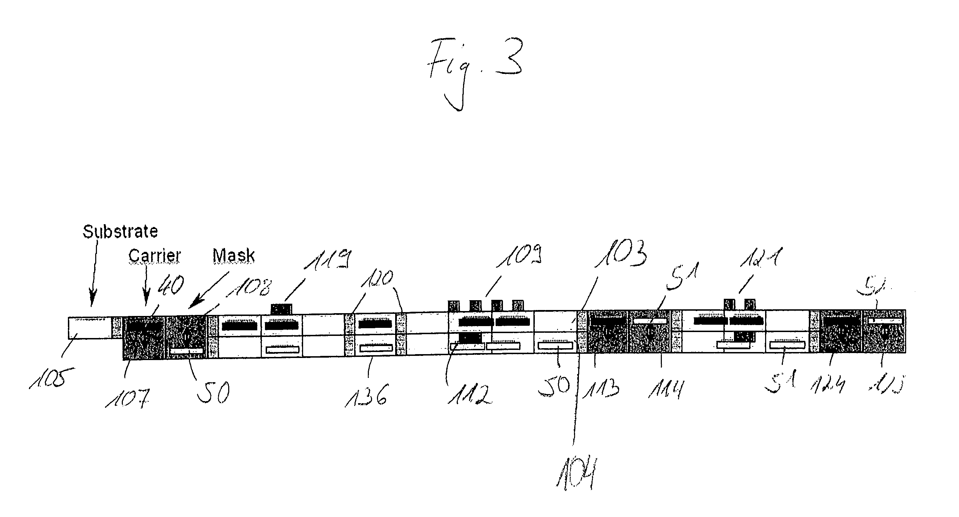

An die Substrateinschleuseinrichtung 5 schließt sich nach einer nicht näher bezeichneten Schleus- oder Abschließvorrichtung die Substratladestation 7 an, bei der das zu beschichtende Substrat auf einem Träger 40 (siehe Fig. 3) angeordnet wird, auf dem sich das Substrat während des Beschichtungsprozesses bzw. während des Transports durch die Vorrichtung 1 befindet. Gleichzeitig stellt die Substratladestation 7 eine Transfereinrichtung, wie im Teilbild rechts unten von Fig. 1 dargestellt, bereit, die einen Wechsel des Trägers 40 aus dem Teil 4 des Vakuumraums in den Teil 3 des Vakuumraums ermöglicht und umgekehrt. Wie später noch gezeigt wird, wechselt der Träger 40 in der Substratladestation seine Transportrichtung von der Trägerrücktransportrichtung in die Substrattransportrichtung.

Alternativ (nicht gezeigt) kann die Substratladestation auch in der Substrateinschleuseinrichtung vorgesehen sein, so dass das Handling des Substrats beim Positionieren auf dem Substratträger in einfacher Weise an Luft und nicht im Vakuum stattfinden kann. In diesem Fall würde sich an die Substrateinschleuseinrichtung lediglich eine Transfermodul anschließen, bei dem der Substratträger aus dem Teil 4 in den Teil 3 überführt und anschließend zur Beladung in die Substrateinschleuseinrichtung transportiert wird. Entsprechend könnte auch der Ausschleusbereich gestaltet sein.

Nach der Substratladestation 7 folgt die Maskenaufbringungsstation 8, bei der auf das im Träger 40 angeordnete Substrat ein Maske (Schattenmaske) (siehe Fig. 3) aufgesetzt oder zugeordnet wird, um bei der nachfolgenden Beschichtung eine Strukturierung der Beschichtung in der Weise zu erzielen, dass das Substrat in den von der Maske abgedeckten Bereichen nicht beschichtet wird, während in den anderen Bereichen eine Beschichtung erfolgt. Zusätzlich wird hier die Maske ausgerichtet bzw. justiert, damit die Strukturierung ortsgenau erfolgen kann.

Auch die Maskenaufbringungsstation 8 umfasst eine nicht näher dargestellte Transfereinrichtung, mit Hilfe der eine Maske aus dem Teil 4 des Vakuumraums in den Teil 3 des Vakuumraums überführt werden kann, wobei gleichzeitig die Maske ebenfalls die Transportrichtung von einer Rücktransportrichtung in eine Substrattransportrichtung wechselt. Bei entsprechender Ausgestaltung mit Handhabungs- und Halteeinrichtungen (nicht gezeigt) können die Substratladestation 7 und die Maskenaufbringungsstation 8 auch in einer einzigen Station kombiniert werden.

An die Maskenaufbringungsstation 8 schließen sich eine Vielzahl von Vakuumdoppelkammern 2 an, die in oder am Teil 3 für entsprechende Beschichtungsprozesse ausgestattet sind.

Im gezeigten Ausführungsbeispiel der Fig. 1 sind Beschichtungsbereiche 9, 10 und 11 vorgesehen, bei denen entsprechende Hilfsschichten, wie Löcherinjektionsschicht HIL, Löchertransportschicht HTL und Elektronenblockierschicht EBL im Bereich 9 sowie das Licht emittierende Material im Bereich 10 und weitere Hilfsschichten, wie Elektroneninjektionsschicht EIL, Elektronentransportschicht ETL und Löcherblockierschicht HBL im Bereich 11 aufgebracht werden.

Nachdem der Träger mit dem darauf angebrachten Substrat sowie der Maske die Beschichtungsbereiche 9 bis 11 durchlaufen hat, gelangt er in die sich anschließe Maskenabnahmestation 13, in der die Maske von dem Substrat entfernt wird. Auch die Maskenabnahmestation 13 weist eine Transfereinrichtung auf, mittels der die abgenommene Maske in den Teil 4 der Vakuumraums transferiert wird, um dort entgegen der Substrattransportrichtung, die in dem Ausfiihrungsbeispiel der Fig. 1 von links nach rechts verläuft, zur Maskenaufbringungsstation 8 zurück transportiert zu werden. Auf dem Weg dahin ist in einer der Vakuumdoppelkammern 2 eine Maskenreinigungsstation 12 vorgesehen, die direkt beim Rücktransport der Maske eine Reinigung der Maske und Entfernung der in den Beschichtungsstationen 9 bis 11 auf gebrachten Beschichtungsstoffe vornimmt. Auf diese Weise kann die Maske sofort wieder in der Maskenaufbringungsstation 8 eingesetzt werden. Die Reinigung kann in jeder geeigneten Weise erfolgen.

Währenddessen bewegt sich der Träger mit dem Substrat in die nach der Maskenabnahmestation 13 angeordnete Maskenaufbringungsstation 14, in der ähnlich zur Maskenaufbringungsstation 8 wiederum eine neue Maske auf dem Substrat aufgebracht wird, um für die nachfolgende Elektrodenaufbringung durch thermische Verdampfung eine entsprechend angepasste Maske zur Verfügung zu stellen.

In der Maskenaufbringungsstation 14 wird die entsprechende Maske genauso wie in der Maskenaufbringungsstation 8 aus dem Teil 4 des Vakuumraums in den Teil 3 des Vakuumraums überführt, wobei die Maske ihre Transportrichtung ändert. Außerdem wird in der Maskenaufbringungsstation 14 genauso wie in der Maskenaufbringungsstation 8 eine Ausrichtung der Maske vorgenommen, so dass die Strukturierung des aufzubringenden Beschichtungsmaterials genau in den Bereichen erfolgt, in denen die Strukturen notwendig sind.

Die nach der Maskenaufbringungsstation 14 folgenden Vakuumdoppelkammern 2 sind im Bereich 15 so ausgestattet, dass eine thermische Verdampfung von Elektrodenmaterial auf das Substrat erfolgen kann. Auch andere Aufdampfungsverfahren sind selbstverständlich anwendbar.

Nach dem Durchlaufen der Beschichtungsstation 15 gelangt das Substrat auf dem Träger und die darauf angeordnete Maske in die Maskenabnahmestation 17, in der die Maske wiederum vom Substrat entfernt und in den Teil 4 des Vakuumraums überführt wird, so dass die Maske entgegen der Substrattransportrichtung zurück transportiert und in der Reinigungsstation 16 gereinigt werden kann, um anschließend sofort wieder in der Maskenaufbringungsstation zur Verfügung zu stehen.

In der für den Träger folgenden Substratentladestation 18 wird das Substrat von dem Träger entnommen und der Substratausschleusstation 6 zugeführt, während der Träger in den Teil 4 des Vakuumraums transportiert und zur Substratladestation 7 zurück bewegt wird.

Beim Rücktransport des Trägers erfolgt der gezeigten bevorzugten Ausführungsform ein gemeinsamer Transport von Maske und Träger, wobei in diesem Fall der Träger in der Maskenabnahmestation 17 die Maske für den Rücktransport aufnimmt und in der Maskenaufbringungsstation 14 entsprechend wieder abgibt. In gleicher Weise nimmt der Träger auf dem Rücktransport im Teil 4 des Vakuumraums in der Maskenabnahmestation 13 die Maske des vorangegangenen Beschichtungsprozesses auf, um sie bis zur Maskenaufnahmestation 8 mitzutransportieren. Allerdings ist es auch vorstellbar getrennte Transportmittel für Träger und Masken für den Rücktransport vorzusehen.

Insgesamt ergeben sich somit in dem Ausführungsbeispiel der Fig. 1 drei Endlosschleifen und zwar eine erste Endlosschleife für den Träger des Substrats, der sich von der Substratladestation 7 im Teil 3 des Vakuumraums (im Bild obere Reihe) über die Maskenaufbringungsstation 8 und die Beschichtungsstationen 9 bis 11 und die Maskenabnahmestation 13 sowie Maskenaufnahmestation 14 und die Beschichtungsstation 15 bis zur Substratentladestation 18 bewegt, um dort seine Transportrichtung zu ändern und dann entgegen der Substrattransportrichtung wiederum bis zur Substratladestation 7 transportiert zu werden. Zusätzlich zu dieser ersten Endlosschleife gibt es zwei zweite Endlosschleifen bezüglich des Maskentransports und zwar einerseits für die Maske für die Beschichtungsprozesse in den Beschichtungsstationen 9 bis 11 und andererseits für die Maske für den Beschichtungsprozess in der Beschichtungsstation 15. Die Maske für den Beschichtungsprozess in den Beschichtungsstationen 9 bis 11 bewegt sich von der Maskenaufbringungsstation 8 über die Beschichtungsstationen 9 bis 11 bis zur Maskenabnahmestation 13, wo die Maske ihre Transportrichtung ändert und im Teil 4 des Vakuumraums über die Maskenreinigungsstation 12 zur Maskenaufbringungsstation 8 zurück transportiert wird.

Die andere Maske des Beschichtungsprozesses der Beschichtungsstation 15 bewegt sich von der Maskenaufbringungsstation 14 im Teil 3 des Vakuumraums über die Beschichtungsstation 15 zur Maskenabnahmestation 17, wo sie ebenfalls die Transportrichtung ändert und im Teil 4 über die Reinigungsstation 16 zur Maskenaufbringungsstation 14 zurück transportiert wird.

Diese auf die bewegten Gegenstände bezogenen Endlosschleifen, also aus der Sicht des Trägers bzw. der Masken sich ergebenden Endlosschleifen können durch eine Vielzahl von Handhabungs- und Übergabeeinrichtungen gebildet werden. Allerdings ist auch vorstellbar, dass insbesondere für die Bewegung des Trägers eine einzige kontinuierliche Beförderungseinrichtung vorgesehen ist.

In gleicher Weise sind für die Substratlade- bzw. -entladestationen 7 und 18 sowie die Maskenaufbringungs- und -abnahmestationen 8 und 14 einerseits sowie 13 und 17 andererseits vielfältige Betätigungsvorrichtungen zur Aufnahme und Bewegung der Masken, Träger, Substrate usw. denkbar.

Als Transfereinrichtung ist beispielsweise für die Substratlade- und -entladestationen 7 und 18 sowie die Maskenaufbringungs- und -abnahmestationen 8, 13, 14 und 17 ein einfacher Drehmechanismus vorstellbar, bei dem eine Trägerplatte 70 um eine Achse 80 verdreht bzw. geschwenkt wird, und zwar um 180°, so dass die Trägerplatte 70 einmal mit ihrer entsprechenden Seite in Richtung des Teils 3 des Vakuumraums weist und das andere Mal nach der Drehung um 180° zum Teil 4 des Vakuumraums zeigt. Bei einer vertikalen Ausrichtung des Substrats, also einer Ausrichtung senkrecht zur Bildebene der Fig. 1 und einem entsprechenden vertikalen Transport, ist die Drehachse 80 der verschwenkbaren Trägerplatte 70 somit ebenfalls senkrecht zur Bildebene angeordnet. Eine entsprechende Darstellung ist im rechten unteren Teil der Fig. 1 gezeigt, wobei die Trägerplatte 70 eine mittige Achse 80 aufweist, um die die Trägerplatte 70 gemäß des Doppelpfeils verschwenkbar ist, so dass der Substratträger 40 zwischen dem Teil 3 und 4 des Vakuumraums gedreht werden kann.

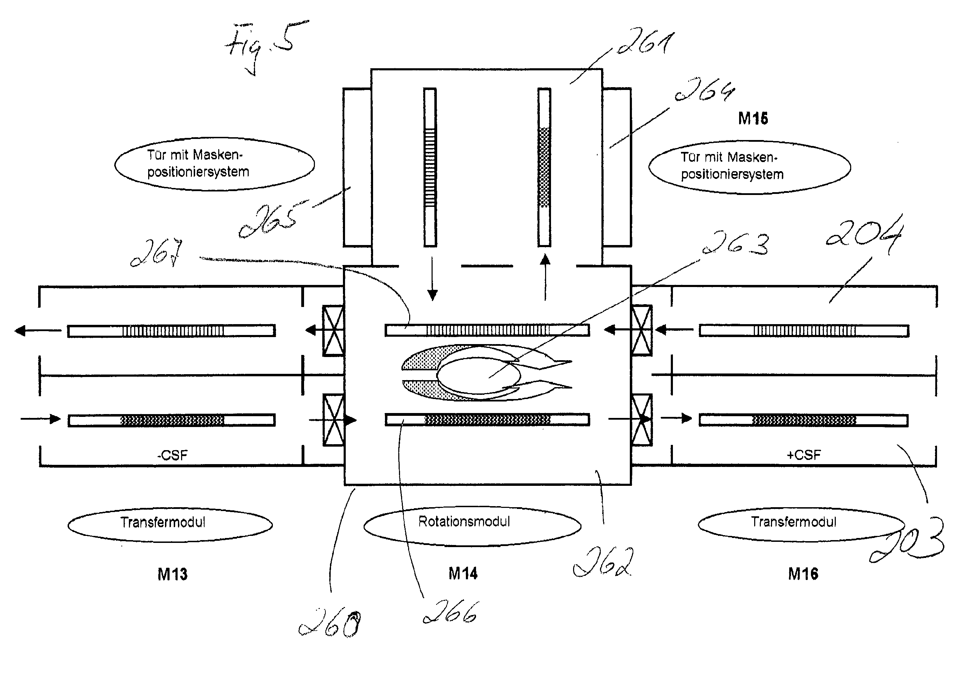

Auf diese Weise ist es auch besonders einfach, eine Kombination von Substratlade- bzw. -entladestationen 7, 18 und Maskenaufbringungs- und -abnahmestationen 8, 13, 14, 17, 18, beispielsweise von Maskenabnahmestation 13 und Maskenaufbringungsstation 14 zu realisieren, da lediglich entsprechende Zwischenhalteeinrichtungen für die abzunehmenden und aufzubringenden Teile vorgesehen sein müssen. Ein entsprechendes Rotationsmodul wird nachfolgend im Zusammenhang mit Fig. 5 beschrieben.

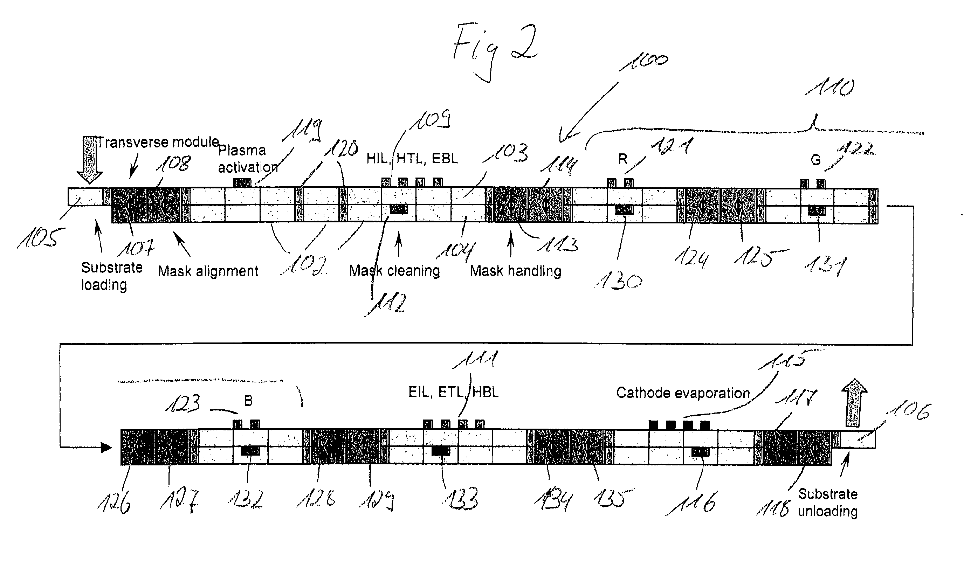

Die Fig. 2 zeigt ein weiteres Ausführungsbeispiel einer erfindungsgemäßen Vorrichtung für die Herstellung von so genannten RGB-Displays, bei denen Pixel von rot-, blau- bzw. grün emittierenden elektrolumineszierenden Materialien in strukturierter Weise separat voneinander hergestellt werden müssen. Entsprechend müssen unterschiedliche Maskierungen für die abzuscheidenden rot-, grün- und blau emittierenden elektrolumineszierenden Materialien mit entsprechenden Maskenaufbringungs- und -abnahmestationen 124, 125, 126, 127, 128, 129 vorgesehen werden. Entsprechend ist auch der Beschichtungsstation 121 für die rot emittierenden elektrolumineszierenden Materialien eine Reinigungsstation 130 sowie für die grüne Beschichtungsstation 122 eine Reinigungsstation 131 und der blauen Beschichtungsstation eine Reinigungsstation 132 für die entsprechenden Masken zugeordnet.

Die Beschichtungsstationen 121, 122 und 123 bilden zusammen den Beschichtungsbereich 110 für das elektrolumineszierende Material. Darüber hinaus sind auch die Beschichtungsbereiche 109 und 111 entsprechend den Beschichtungsbereichen 9 und 11 der Ausfi.ihrungsform der Flg. 1 vorgesehen, in der die entsprechenden Hilfsschichten wie Löcher induzierende Schicht, Löchertransportschicht, EBL-Schicht, Elektronen induzierende Schicht, Elektrone transportierende Schicht und HBL-Schicht aufgebracht werden. Auch diesen Beschichtungsstationen 109 und 111 sind für die dort verwendeten Masken Reinigungsstationen 112 und 133 zugeordnet. Darüber hinaus ist neben der Elektrodenbeschichtungsstation 115 eine Plasmaaktivierungsstation 119 am Beginn der Vorrichtung 100 vorgesehen, bei der das Substrat bzw. dessen Oberfläche für die nachfolgende Beschichtung plasmaaktiviert wird.

Auch die Vorrichtung 100 ist mit ihrem Vakuumraum entlang der Längsachse zweigeteilt, in den Teil 103 und den Teil 104, wobei in Teil 103 bzw. entsprechend an den dort vorgesehenen Teilen 103 der Vakuumdoppelkammern 102 die entsprechenden Substratbehandlungs- und Beschichtungsstationen 109, 110, 111, 115 und 119 vorgesehen sind, während dem oder den Teilen 104 die Reinigungsstationen 112, 130, 131, 132, 133 und 116 zugeordnet bzw. an diesen oder in diesen angeordnet sind.

Ähnlich wie die Schleusen- oder Abschließvorrichtung 20 des Ausführungsbeispiels der Fig. 1 zum Abtrennen bzw. Abschotten einzelner Bereiche, insbesondere im Bereich der Maskenaufbringung- und -abnahmestationen sind auch bei der Ausführungsform der Vorrichtung 100 entsprechende Schleusen- bzw. Abschließvorrichtungen 120 vorgesehen, die beispielsweise zwischen der Plasmaaktivierungsstation 119 und der Beschichtungsstation 109 zur Abtrennung der entsprechenden Atmosphären und Bildung eines Schleusenbereichs für die Substrate vorgesehen sind.

Insgesamt ergibt sich somit ein Aufbau der Vorrichtung 100 mit einer Substrateinschleusstation 105, einer Substratladestation 107, einer Maskenaufbringungsstation 108 und einer Endlosschleife für den Träger mit nicht näher dargestellten Transportmitteln, die den Träger mit aufgebrachtem Substrat und wechselnden Masken zunächst an der Plasmaaktivierungsstation 119, anschließend an der Beschichtungsstation 109 sowie den weiteren Beschichtungsstationen 121, 122, 123 und 111 sowie 115 vorbeibewegt, um schließlich in der Substratentladestation 118 das Substrat von dem Träger zu trennen und das Substrat in der Substratausschleusstation 106 auszugeben bzw. nachfolgenden Behandlungseinrichtungen zur Verfügung zu stellen. Der Träger wird dann ohne Substrat und wiederum mit wechselnden Masken im zweiten Teil 104 des Vakuumraumes zur Substratladestation 107 zurückbewegt, wobei er die Reinigungsstationen 116, 133, 132, 131, 130 und 112 in dieser Reihenfolge passiert.

Neben dieser ersten Endlosschleife weist die Vorrichtung 106 zweite Endlosschleifen für die entsprechenden Masken auf, wobei die erste Maske in der Maskenaufbringungsstation 108 auf das Substrat bzw. auf den Träger in Bezug zu dem Substrat angeordnet und ausgerichtet wird, um das Substrat während des Passierens der Plasmaaktivierungsstation 119 und der Beschichtungsstation 109 in den entsprechenden Bereichen zu schützen und nur gegenüber vorher definierten Bereiche freizugeben. In der Maskenabnahmestation 113 wird diese Maske von dem Substrat bzw. dem Träger entfernt und im Vakuumteilraum 104 unter Passieren der Maskenreinigungsstation 112 zur Maskenaufbringungsstation 108 zurücktransportiert. Falls eine Plasmaaktivierung der gesamten Oberfläche des Substrats gewünscht wird, kann die Maskenaufbringungs- und -ausrichtungsstation 108 auch zwischen der Plasmaaktivierungsstation 119 und der Beschichtungsstation 109 vorgesehen werden. Anstelle der Plasmaaktivierung sind auch andere Bearbeitungstechniken zur Reinigung und/oder Aktivierung für die Oberfläche, insbesondere Oberflächenaktivierungstechniken denkbar, wie UV-OzonBehandlung oder Ionenbeschuss.

Die zweite Endlosschleife zweiter Art zum Transport einer entsprechenden Maske ist für den Beschichtungsbereich 121 vorgesehen, wobei die Maske in der Maskenaufbringungsstation 114 aufgebracht und justiert und in der Maskenabnahmestation 124 vom Substrat bzw. Träger entfernt und in der Reinigungsstation 130 gereinigt wird.

Die dritte, vierte, fünfte und sechste Endlosschleife zweiter Art ist den Beschichtungsstationen 122, 123, 111 und 115 zugeordnet, wobei jeweils in den entsprechenden Maskenaufbringungsstationen 125, 127, 129 und 135 die Masken für den nachfolgenden Beschichtungsprozess auf das Substrat bzw. dem Träger aufgebracht und ausgerichtet werden, während in den nach den jeweiligen Beschichtungsstationen angeordneten Maskenabnahmestationen 126, 128, 134 und 117 die entsprechenden Masken wieder entfernt werden.

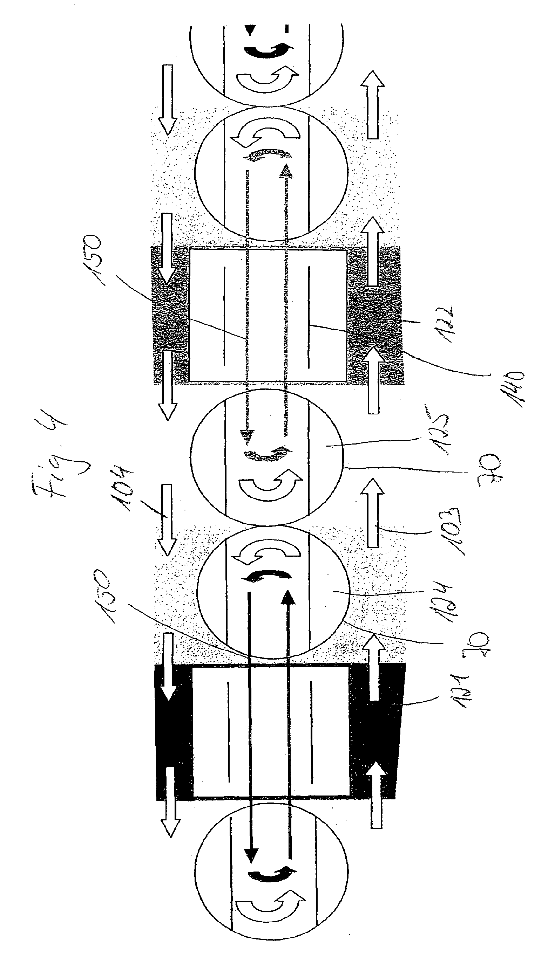

Diese Funktionsweise wird durch die schematischen Darstellungen der Fig. 3 und 4 noch verdeutlicht, wobei in Fig. 3 für einen Teilabschnitt der Vorrichtung 100 aus Fig. 2 der Transport- bzw. Bewegungsfluss für den Träger 40 und die Masken 50 und 51 bzw. 52 dargestellt ist. Wie in Fig. 3 deutlich zu sehen ist, bewegen sich sowohl in den ersten als auch in den zweiten Endlosschleifen gleichzeitig immer mehrere Träger und Masken, so dass ein hoher Durchsatz durch die Beschichtungsanlage gewährleistet ist. Wie durch die Doppelpfeile in den Maskenaufbringungsstationen 108, 114 und 125 sowie den Maskenabnahmestationen 113 und 124 sowie der Substratladestation 107 angedeutet ist, erfolgt in diesen Stationen der Wechsel des Trägers 40 von dem zweiten Abschnitt der Transporteinrichtung für den Träger im Teil 104 des Vakuumraums auf den ersten Abschnitt der Transporteinrichtung im Teil 103 des Vakuumraums bzw. für die Masken von dem zweiten Abschnitt der Transportanordnung für die Masken im Teil 104 des Vakuumraums auf den ersten Abschnitt der Transportanordnung der Masken im Teil 103 des Vakuumraums (Maskenaufbringungsstationen) bzw. umgekehrt (Maskenabnahmestationen).

Wie sich insbesondere aus Fig. 4 ergibt, können die schematisch dargestellte erste Endlosschleife 140 und die zweiten Endlosschleifen 150 vorzugsweise identische Transportmittel und Handhabungseinrichtungen zur Realisierung der Transporteinrichtung für den Träger bzw. der Transportanordnung für die Masken aufweisen.

In Fig. 4 ist die Übergabe der Masken beim Wechsel von der roten Beschichtungsstation 121 auf die grüne Beschichtungsstation 122 in der Maskenabnahmestation 124 und der Maskenaufnahmestation 125 durch beispielsweise drehbare Trägerplatten 70, wie in Fig. 1 dargestellt, schematisch visualisiert. In der Maskenabnahmestation 124 wird der Träger mit der Maske aus dem roten Beschichtungsbereich 121 durch Drehung der Trägerplatte 70 von dem ersten Teil 103 des Vakuumraums in den zweiten Teil 104 des Vakuumraums überführt, um dort die Maske für den roten Beschichtungsbereich abzugeben. Dann wird die Trägerplatte 70 zurückgedreht, so dass der auf der Trägerplatte 70 angeordnete Träger 40 (nicht gezeigt) mit dem darauf angeordneten Substrat sich wieder im Bereich des ersten Teils 103 des Vakuumraums befindet. Dann folgt der Weitertransport des Substrats mit dem Träger in die Maskenaufbringungsstation 125 des grünen Bereichs 122, wobei hier zunächst wiederum die Trägerplatte 70 um 180° gedreht wird, so dass das Substrat mit dem Träger wiederum im Teil 104 des Vakuumraums angeordnet ist. Dort übernimmt der Träger bzw. das Substrat die im Teil 104 des Vakuumraums zurücktransportierte und gereinigte Maske des grünen Bereichs um nach der Anordnung und Ausrichtung der grünen Maske wieder durch eine Drehung um 180° in den Teil 103 des Vakuumraums zurückgedreht zu werden, so dass dort der Transport des Trägers mit Substrat und nunmehr grüner Maske durch den grünen Bereich fortgesetzt werden kann. Eine derartige Abfolge ist zwischen allen Beschichtungs- bzw. Substratbehandlungsstationen und auch für die Substratlade- und -entladestation realisierbar.

Bei Verwendung entsprechender Handhabungsmittel, die eine kurzfristige Zwischenlagerung von zumindest jeweils einer der entsprechenden Masken erlauben, ist auch die Kombination von Maskenaufbringungs- und Maskenabnahmestationen in einer einzigen Station vorstellbar, wie dies in Fig. 5 gezeigt ist. Allerdings ist zur Vermeidung von gegenseitigen Kontaminationen der verschiedenen Beschichtungsbereiche die räumliche Trennung vorteilhaft, auch wenn dies einen etwas höheren Handhabungsaufwand darstellt. Für Beschichtungsstationen oder Substratbehandlungsstationen, in denen jedoch keine Kontaminationen zu befürchten sind oder wenn entsprechende Abtrennungen vorgesehen sind, kann eine derartige Kombination verwirklicht werden.

Im Beispiel der Fig. 5 ist ein Rotationsmodul 260 mit einem Drehbereich 262 und einem Maskenwechselbereich 261 vorgesehen. In das Rotationsmodul 260 werden im Teil 203 der Transporteinrichtung, in der die Beschichtung stattfindet, die Substratträger 266 mit entsprechend beschichteten Masken eingebracht, während im Teil 204 die Substratträger 267 mit gereinigten Masken des benachbarten Beschichtungsbereich übergeben werden, wobei die Transportrichtungen entgegengesetzt sind. Nach Aufnahme der Substratträger 266,267 auf dem Drehtisch 263 wird dieser um 90° gedreht, so dass die Substratträger 266,267 in den benachbarten Maskenwechselbereich 261 überführt werden können. Dort sind an den Außenwänden Maskenpositioniersysteme 264 und 265 angeordnet, die die Masken von den Substratträgern 266,267 übernehmen. Während die Maskenpositioniersysteme 264 und 265 die Masken halten, werden die Substratträger wieder auf den Drehtisch 263 bewegt, dort um 180° gedreht und wieder in den Maskenwechselbereich 261 eingebracht. Dort übernimmt dann der Substratträger 266 die saubere Maske des nachfolgenden Beschichtungsbereichs, während der Substratträger 267 mit der beschichteten Maske nach einer weiteren Drehung um 90° in den Reinigungsbereich des anderen Beschichtungsbereichs fährt.

## Patentansprüche

1. Vorrichtung zur insbesondere kontinuierlichen Herstellung von mit organischen elektrolumineszierenden Materialen (OLED) versehenen Substraten, insbesondere OLED-Displays, -Bildschirmen, -Anzeigen oder sonstigen Beleuchtungselementen, mit einem Vakuumraum und einer Transporteinrichtung zum Transport der zu beschichtenden Substrate, welche zumindest teilweise entlang des Vakuumraums angeordnet ist und Träger für die Substrate aufweist,
**dadurch gekennzeichnet, dass**
die Transporteinrichtung zumindest eine Endlosschleife (140) für den Transport der Träger (40) umfasst, wobei der Vakuumraum zumindest zweigeteilt mit einem ersten Teil (3,103), in dem ein erster Abschnitt der Transporteinrichtung für den Transport der Träger (40) in eine erste Richtung (Substrattransportrichtung) vorgesehen ist, und mit einem zweiten Teil (4,104) ist, in dem ein zweiter Abschnitt der Transporteinrichtung für den Transport der Träger in eine zweite Richtung (Trägerrücktransportrichtung) vorgesehen ist.

2. Vorrichtung nach Anspruch 1,
**dadurch gekennzeichnet, dass**
der Vakuumraum aus einer Vielzahl von nebeneinander angeordneten Kammern (2,102) aufgebaut ist, die voneinander abtrennbar sind und einen ununterbrochenen Transport der Substrate und/oder Träger (40) und/oder Masken (50,51,52) im Vakuum erlauben und/oder dass zusätzlich Schleusenkammern und/oder -einrichtungen (20,120) entlang der Endlosschleife vorgesehen sind.

3. Vorrichtung nach einem der vorhergehenden Ansprüche,
**dadurch gekennzeichnet, dass**
die Zweiteilung des Vakuumraums durch Vakuumdoppelkammern (2,102) gebildet ist, die zumindest teilweise hintereinander angeordnet sind.

4. Vorrichtung nach einem der vorhergehenden Ansprüche,
**dadurch gekennzeichnet, dass**
mindestens eine zweite, vorzugsweise mehrere zweite Endlosschleifen (150) zum Transport von Masken (50,51,52) im Vakuumraum vorgesehen sind, vorzugsweise jeweils eine für den Bereich (10,110) der Abscheidung von organischen elektrolumineszierenden Materialien, insbesondere von rot (121), grün (122) und blau (123) emittierenden organischen elektrolumineszierenden Elementen, wobei insbesondere ein erster Abschnitt der Transportanordnung der zweiten Endlosschleife (150) im ersten Teil (3,103) des Vakuumraums und ein zweiter Abschnitt der Transportanordnung der zweiten Endlosschleife (150) im zweiten Teil (4,104) des Vakuumraums vorgesehen sind.

5. Vorrichtung nach einem der vorhergehenden Ansprüche,
**dadurch gekennzeichnet, dass**
mindestens jeweils eine, vorzugsweise mehrere Substratlade- (7,107) und - entladestationen (18,118) für die Anordnung bzw. Entladung der Substrate vom Träger und/oder Maskenaufbringungs- und/oder -abnahmestationen und/oder Maskenausrichtungsstationen (8,13,14,17;108,113,114,117,124,125,126,127,128,129,134,13 5) vorgesehen sind.

6. Vorrichtung nach einem der vorhergehenden Ansprüche,
**dadurch gekennzeichnet, dass**
Transfereinrichtungen, insbesondere in den Substratlade- (7,107) und -entladestationen (18,118) und/oder Maskenaufbringungs- und -abnahmestationen (8,13,14,17;108,113,114,117,124,125,126,127,128,129,134,135) zum Wechsel von Trägern (40) und/oder Masken (50,51,52) von dem ersten Teil (3,103) des Vakuumraums zum zweiten Teil (4,104) und umgekehrt.

7. Vorrichtung nach einem der vorhergehenden Ansprüche,
**dadurch gekennzeichnet, dass**
entlang der ersten Endlosschleife (140) jeweils ein oder mehrere Beschichtungstationen (9,10,11,15; 109,110,111,115), die Vakuumbeschichtungsverfahren, insbesondere chemische Dampfphasenabscheidung (CVD), physikalische Dampfphasenabscheidung (PVD), insbesondere Sputterverfahren, Plasma unterstütze Beschichtungsverfahren, Aufdampfverfahren mit oder ohne Trägergas umfassen, Reinigungsstationen (12,16;112,116,130 bis 133) für das Substrat, für die Träger und/oder die Masken und/oder sonstige Substratbehandlungsstationen, insbesondere Substrataktivierungsstationen (119), insbesondere Plasmaaktivierungsstationen und/oder Stationen zur UV-Ozon, lonenstrahl- oder Glimmentladungsbehandlung vorgesehen sind, wobei insbesondere für die Plasmaaktivierung und Abscheidung der Löcherinjektions- (HIL), Löchertransport- (HTL) und Elektronenblockier- (EBL)-Schicht eine zweite Endlosschleife zum Transport einer für diesen Beschichtungsprozess angepassten Maske und/oder für die Abscheidung der elektrolumineszierenden Materialien die gleiche oder insbesondere für jedes rot, blau oder grün emittierende Material eine weitere zweite Endlosschleife zum Transport einer für diese(n) Beschichtungsprozess(e) angepassten Maske und/oder für die Abscheidung der Elektroneninjektions- (EIL), Elektronentransport- (ETL) und Löcherblockier- (HBL)-Schicht die gleiche oder eine weitere zweite Endlosschleife zum Transport einer für diesen Beschichtungsprozess angepassten Maske und/oder für die Abscheidung der Elektroden, insbesondere mittels Vakuumbeschichtungsverfahren, insbesondere chemische Dampfphasenabscheidung (CVD), physikalische Dampfphasenabscheidung (PVD), insbesondere Sputterverfahren, Plasma unterstütze Beschichtungsverfahren, Aufdampfverfahren mit oder ohne Trägergas, eine weitere zweite Endlosschleife zum Transport einer für diesen Beschichtungsprozess angepassten Maske vorgesehen sind.

8. Vorrichtung nach Anspruch 7,
**dadurch gekennzeichnet, dass**
die Beschichtungs- und Substratbehandlungsstationen (9,10,11,15; 109,110,111,115,119) entlang des ersten Abschnitts der Transporteinrichtung im oder am ersten Teil (3,103) des Vakuumraums und die Reinigungsstationen (12,16;112,116,130 bis 133) für die Masken und/oder Träger entlang des zweiten Abschnitts der Transporteinrichtung im oder am zweiten Teil (4,104) des Vakuumraums, insbesondere an den Außenwänden angeordnet sind.

9. Vorrichtung nach einem der vorhergehenden Ansprüche,
**dadurch gekennzeichnet, dass**
ein Rotationsmodul (260) vorgesehen ist, in dem Maskenaufbringungs- und - abnahmestation von benachbarten Beschichtungsbereichen integriert sind, wobei ein Drehbereich (262) und ein Maskenwechselbereich (261) vorgesehen sind, und wobei im Drehbereich ein Drehmechanismus (263) vorgesehen ist, mit dem zwischen den Transportabschnitten (203,204) und/oder dem Maskenwechselbereich gewechselt werden kann.

10. Vorrichtung nach einem der vorhergehenden Ansprüche,
**dadurch gekennzeichnet, dass**
die Endlosschleifen (140,150) eine einzige kontinuierliche Beförderungseinrichtung und/oder eine Vielzahl von Handhabungs- und Übergabeeinrichtungen umfassen.

11. Vorrichtung nach einem der vorhergehenden Ansprüche,
**dadurch gekennzeichnet, dass**
erste (140) und zweite (150) Endlosschleifen zumindest teilweise dieselben Beförderungs- und Handhabungseinrichtungen verwenden.

12. Vorrichtung nach einem der vorhergehenden Ansprüche,
**dadurch gekennzeichnet, dass**
an der ersten Endlosschleife (140) am Beginn des ersten Abschnitts der Transporteinrichtung eine Substrateinschleuseinrichtung (5,105) und vorzugsweise am Ende des ersten Abschnitts der Transporteinrichtung eine Substratausschleuseinrichtung (6,106) vorgesehen ist.

13. Vorrichtung nach einem der vorhergehenden Ansprüche,
**dadurch gekennzeichnet, dass**
die Vorrichtung als kontinuierlich arbeitende Anlage (in-line) im Wesentlichen linear ausgebildet ist.

14. Verfahren zur insbesondere kontinuierlichen Herstellung von mit organischen elektrolumineszierenden Materialen (OLED) versehenen Substraten, insbesondere OLED-Displays, -Bildschirmen, -Anzeigen oder sonstigen Beleuchtungselementen, insbesondere mit einer Vorrichtung nach einem der vorhergehenden Ansprüche, umfassend die Schritte:
a) Anordnung eines Substrats auf einem Träger (40) für den Transport durch eine Vakuumbeschichtungsanlage in einer Substratladestation (7,107),
b) Aufbringung einer Maske auf dem Substrat oder dem Träger in Bezug zu dem Substrat in einer Maskenaufbringungsstation (8,14;108,114,125,127,129,135) zur Abscheidung einer strukturierten Beschichtung,
c) Durchführung der strukturierten Beschichtung, insbesondere von elektrolumineszierenden Materialien,
d) Entfernung der Maske in einer Maskenabnahmestation (13,17;113,124,126,128,134, 117) und sofortiger Rücktransport der Maske zur Maskenaufbringungsstation (8,14;108, 114,125,127,129,135) entgegen, insbesondere antiparallel der Substrattransportrichtung
e) Reinigung der Maske auf dem Rücktransport,
f) Bereitstellung der gereinigten Maske in der Maskenaufbringungsstation (8,14;108,114, 125,127,129,135),
g) Weitertransport des Trägers (40) mit dem beschichteten Substrat zur Entladung aus der Vakuumbeschichtungsanlage oder Durchführung weiterer Beschichtungen.

15. Verfahren nach Anspruch 14,
**dadurch gekennzeichnet, dass**
der Rücktransport der Maske im Vakuum erfolgt.

16. Verfahren nach Anspruch 14 oder 15,
**dadurch gekennzeichnet, dass**
die Schritte b) bis g) mehrmals hintereinander erfolgen.

17. Verfahren nach einem der Ansprüche 14 bis 16,
**dadurch gekennzeichnet, dass**
der Träger nach der Entladung des Substrats sofort insbesondere entgegen, vorzugsweise antiparallel zur Substratladestation zurück transportiert wird, wobei insbesondere zumindest teilweise der Transport mit einer Maske erfolgt.

18. Verfahren nach einem der Ansprüche 14 bis 17,
**dadurch gekennzeichnet, dass**
in der Maskenaufbringungsstation und/oder der Maskenabnahmestation eine Übergabe der Maske von der Substrattransportrichtung zur Rücktransportrichtung und umgekehrt erfolgt.
